# EUROPEAN PATENT SPECIFICATION

(11) **EP 4 345 432 B1**
(45) Date of publication and mention of the grant of the patent: **28.05.2025**
(21) Application number: 23196916.3
(22) Date of filing: 12.09.2023
(51) Int. Cl.: G01K 1/143, G01K 7/42, G01R 19/00, G01R 31/00, H01L 23/00, G01K 3/00, G01R 31/26, H01L 23/053, H01L 23/34, H01L 23/538, H01L 25/16, H01L 25/07

(54) **ACCURATE AND FAST POWER MODULE TEMPERATURE ASSESSMENT**
GENAUE UND SCHNELLE BEURTEILUNG DER LEISTUNGSMODULTEMPERATUR
ÉVALUATION PRÉCISE ET RAPIDE DE LA TEMPÉRATURE D'UN MODULE DE PUISSANCE

(30) Priority: 30.09.2022 US 202217957333
(43) Date of publication of application: 03.04.2024
(73) Proprietor: GE Aviation Systems LLC, Grand Rapids, MI 49512 (US)
(72) Inventor: LEE, Shung Ik, 33069-4323 Pompano Beach (US); YANG, Liqiang, 33069-4323 Pompano Beach (US); GRIMES, Darrell, 33069-4323 Pompano Beach (US); CHO, Hyunmin, 33069-4323 Pompano Beach (US); EDDINS, Richard, 49512 Grand Rapids (US); SMOLENSKI, Joseph, 49512 Grand Rapids (US)
(74) Representative: Openshaw & Co.

(56) References cited:
- CN-A- 112 327 127
- US-A1- 2014 138 807
- US-A1- 2021 296 217
- US-A1- 2022 070 996

## Description

### Technical Field

These teachings relate generally to power modules and more particularly to junction temperature measurement of power modules.

### Background

Power modules employ transistors to output stable and reliable power for a variety of applications including use in aircraft and similar high-performance systems. Further, the operation of power modules can produce a sizable amount of heat that, if not properly managed, can damage the power module and/or produce unreliable operating conditions and power output. As such, control circuity is often employed to consider temperature when operating the power module.

US 2022/070996 A1 discloses a power module having a conductive layer for electrically connecting a plurality of power transistors. US 2021/296217 A1 discloses a power transistor comprising a temperature sensor which is mounted on a lead frame. CN 112 327 127 A discloses a power transistor comprising a platinum RTD directly on the die.

### Brief Description of the Drawings

Various needs are at least partially met through provision of the accurate and fast assessment or measurement of various properties of power modules described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 comprises a schematic view of a power module as configured in accordance with various embodiments of these teachings;
FIG. 2 comprises a partial cross-sectional view of a power module as configured in accordance with various embodiments of these teachings;
FIG. 3 comprises a schematic view of a power module as configured in accordance with various embodiments of these teachings;
FIG. 4 comprises a partial cross-sectional view of a power module as configured in accordance with various embodiments of these teachings;
FIG. 5 comprises a schematic view of a power module as configured in accordance with various embodiments of these teachings;
FIG. 6 comprises a perspective view of a control circuit for a power module as configured in accordance with various embodiments of these teachings; and
FIG. 7 comprises a flow diagram of a method in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### Detailed Description

Typical power modules are constructed from a plurality of transistors with a plurality of surface wire bonds on a die surface for interconnecting the transistors and control circuitry together. As such, these modules do not provide an area for direct temperature sensing on the die surface. Rather, the modules employ alternative temperature sensing from printed circuit board (PCB) control circuitry, including indirect methods such as measuring a body diode, expensive optical method, or the like. The lack of a simple direct temperature measurement method increases operational costs and limits reliability and safety.

Generally speaking, the various aspects of the present disclosure can be employed with a power module comprising one or more power transistors and a conductive overlay for each of the one or more power transistors to provide a direct mounting surface for sensors such as a temperature sensor that can provide a direct temperature measurement for the one or more power transistors. The conductive overlay can include a well-defined metallic and stable surface that is directly connected to the power transistor die surface with short-distance metal connections. The additional surface of the conductive overlay makes it is possible to position a temperature sensor on top to provide fast and accurate sensing capability to improve reliability of module operation. This sensor can be easily wired to a PCB controller and data from the sensor can be provided to a gate board to provide for reliable module operation. The direct temperature measurement can result in increased reliability and safety when operating power modules.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

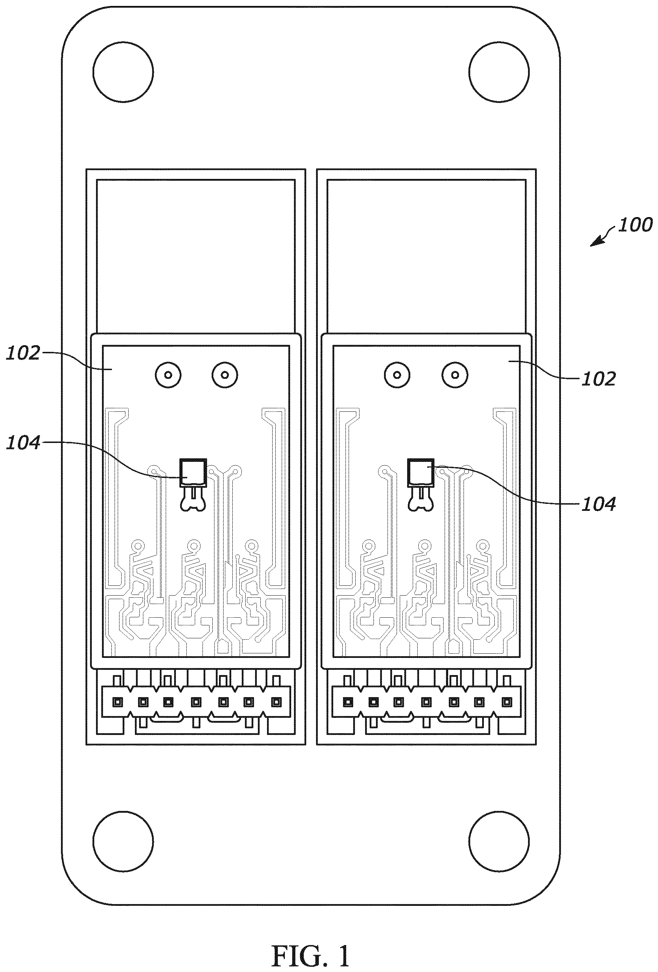

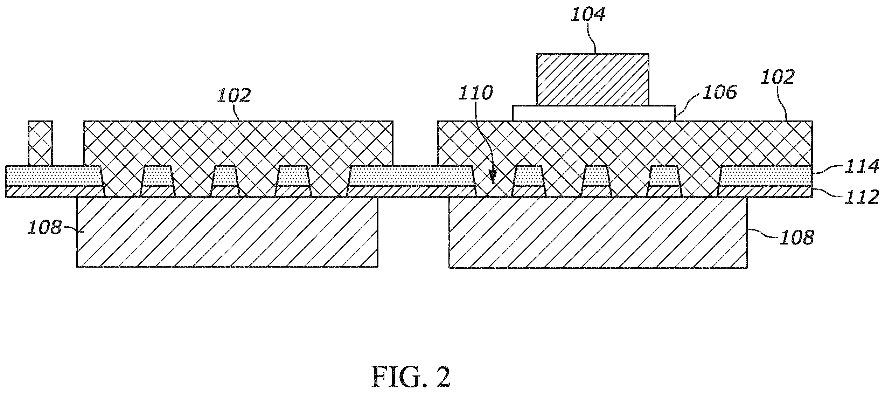

The foregoing and other benefits may become clearer upon making a thorough review and study of the following detailed description. Referring now to the drawings, and in particular to FIG. 1, a power module 100 is presented. The power module 100 includes conductive overlays 102 having temperature sensors 104 adhered or bonded to a top surface thereof. In some embodiments, the conductive overlays 102 can include a copper or other conductive material power overlay (POL) sufficient to provide a coupling surface for the temperature sensors 104. Such a POL configuration can provide a planar interconnection region where various system inputs and outputs and external devices can interface with one or more power transistors 108 (see FIG. 2). Examples of a POL that may form the conductive overlays 102 described herein are provided in US Patent 10,269,688. However, it will be appreciated that the embodiments described herein are also applicable with respect to alternative planar interconnect technologies such as copper clips, multilayer organic PCB, etc. and also flip chip and chip-in-polymer technologies.

Turning now to FIG. 2, a partial cross-section view of the power module 100 is shown. The power module 100 can further include heat conductive epoxy 106 for bonding the temperature sensors 104 to the conductive overlays 102. The heat conductive epoxy 106 can serve as a heat transfer medium between the top surface of the conductive overlays 102 and the temperature sensors 104 so that the temperature sensors 104 get consistent and accurate readings therefrom. The temperature sensors 104 can be attached with the heat conductive epoxy 106 on the wide, well defined, metallic, and stable surface of the conductive overlays 102. Further, the position of the temperature sensors 104 can correspond to the highest temperature locations on the conductive overlays 102. In some embodiments, the highest temperature locations can be identified by modeling operation of the power module 100. In some embodiments, the temperature sensors 104 can be attached to the conductive overlays 102 over a central one of the one or more power transistors 108, which modeling and testing indicates as the hottest location for the power module 100. However, it will be appreciated that other locations are also contemplated and in some embodiments multiple temperature sensors may be positioned in close proximity to the same general location.

The temperature sensors 104 can include thermocouples and/or a resistance temperature detector having a non-conductive housing.

The one or more power transistors 108 have respective die surfaces over which the conductive overlays 102 are positioned. The power transistors 108 can include Silicon-carbide (SiC) MOSFETs or similar power transistors known in the art.

A non-conductive layer 114 and an adhesive layer 112 can be positioned between the conductive overlays 102 and the one or more power transistors 108. The non-conductive layer 114 can act as a dielectric layer between the respective die surfaces of the power transistors 108 and the conductive overlays 102. The non-conductive layer 114 can include Kapton or other similar material.

Further, the conductive overlays 102 can include vias 110 that electrically couple the conductive overlays 102 to the one or more power transistors 108. In these embodiments, the vias 110 can pass through the non-conductive layer 114 and the adhesive layer 112 to provide a direct metallic connection between the conductive overlays 102 and the one or more power transistors 108. Additionally or alternatively, in some embodiments, one or more sintered layers can be utilized to interconnect the conductive overlays 102 to the surfaces of the one or more power transistors.

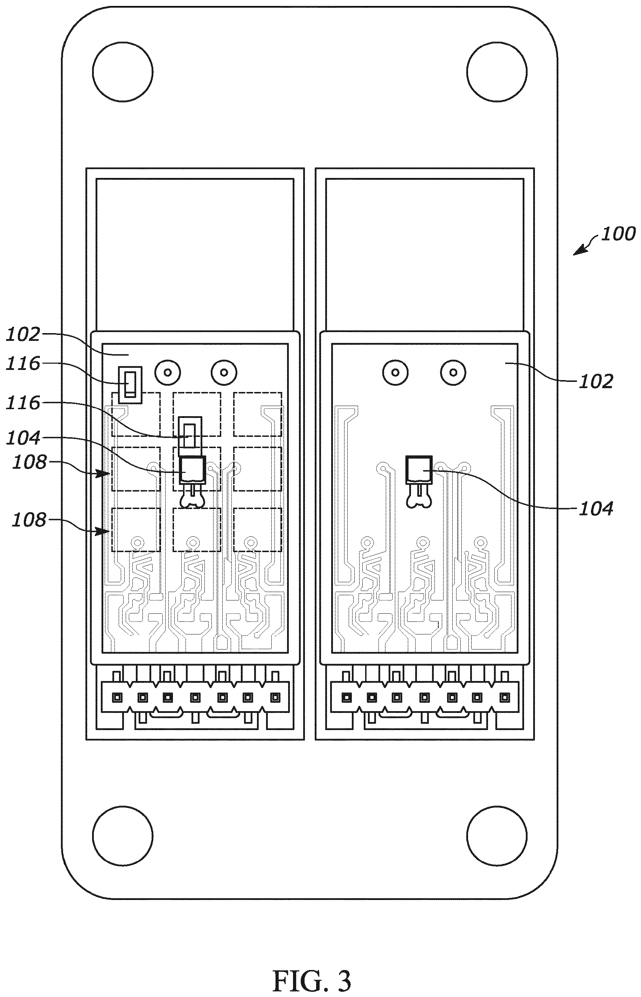

Turning now to FIG. 3, another schematic view of the power module 100 is shown. As seen in FIG. 3, in some embodiments, the power module 100 can include additional sensors coupled to the conductive overlays 102. The additional sensors can include a plurality of current sensors 116 that are physically bonded and electrically coupled to the conductive overlays 102 to measure current flow between two of the one or more power transistors 108 or other elements of the power module 100.

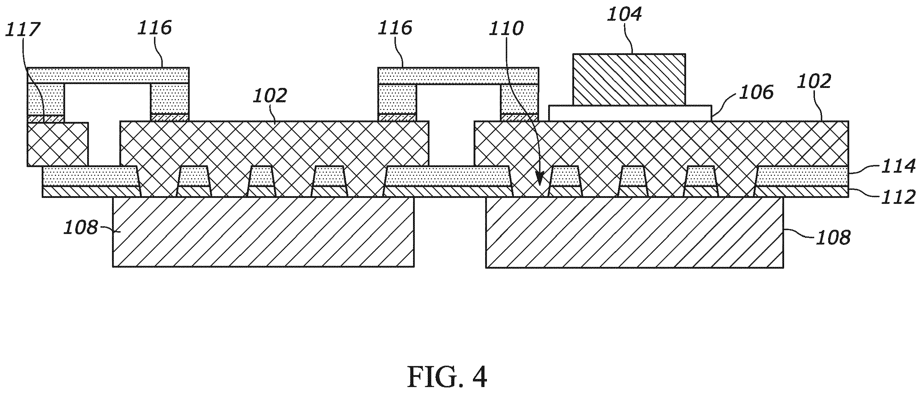

As seen in the additional partial cross-section view of the power module 100 of FIG. 4, the current sensors 116 can be bonded to the conductive overlays 102 with solder 117 and can bridge over gaps between sections of the conductive overlays 102. The current sensors 116 can include current sensing shunts that are attached to the conductive overlays 102 during an assembly process for the power module 100. The current sensors 116 can be positioned between other current or temperature sensors or between top copper sections of the conductive overlays 102 to provide for a local current value.

In some embodiments, the conductive overlays 102 are displaced a distance from the respective die surface of each of the plurality of transistors 108 such that the temperature sensors 104 and/or the plurality of current sensors 116 coupled to the top surface of the conductive overlays 102 are also displaced from the respective die surface of each of the plurality of transistors 108 by the distance. The vias 110 can bridge the distance to electrically couple the conductive overlay 102 to each of the one or more power transistors 108.

The distance between the top surface of the conductive overlays 102 to which the temperature sensors 104 and solder current sensors 116 are coupled and the top surface of the power transistors 108 can be approximately 150um, where 100um of the distance results from a thickness of the conductive overlays 102 and 50um of the distance results from a thickness of the vias 110. The short distance between the top surface of the power transistors 108 and the top surface of the conductive overlays 102 to which the temperature sensors 104 are coupled can increase the accuracy of temperature measurement as compared to other indirect temperature measurement methods. In particular the close distance helps to ensure that the temperature reading closely corresponds to the actual temperature of the top surface of the power transistors 108 because the distance limits dissipation of heat before it is read by the temperature sensors 104 and/or limits the influence of other heat sources on the temperature value read by the temperature sensors 104.

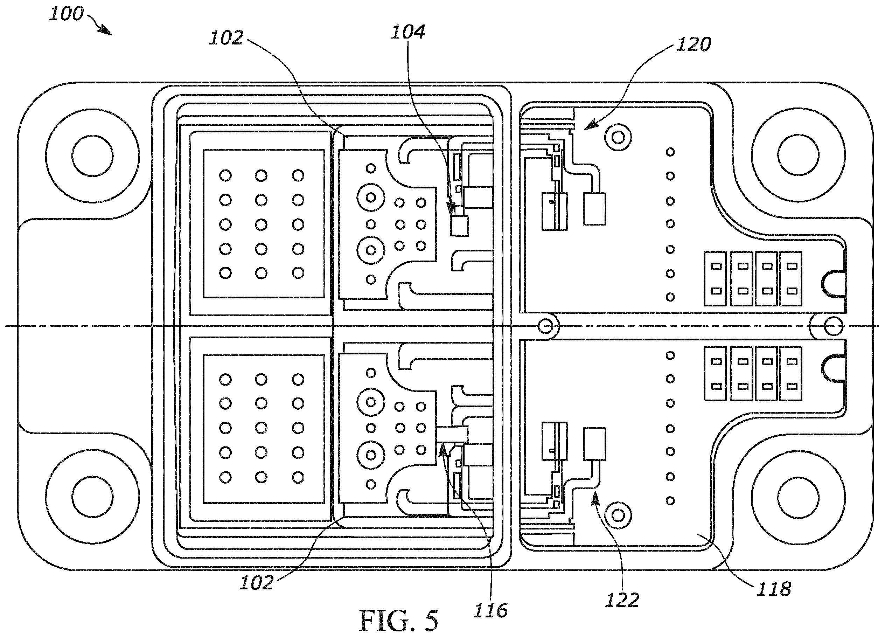

Turning now to FIG. 5 another schematic of the power module 100 is shown. As seen in FIG. 5, the temperature sensors 104 and the plurality of current sensors 116 can be electrically coupled to control circuit 118 via wires and solder 120 and 122 respectively.

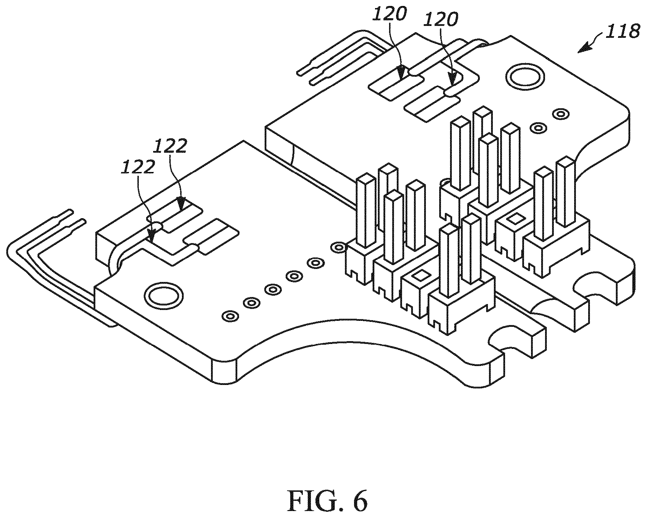

As seen in FIG. 6, the control circuit 118 can include a printed circuit board that can rest within a housing that contains the rest of the power module 100. The control circuit 118 can pass signals to a gate board that is connected to the control circuit 118 to assist in controlling operation of the one or more power transistors 108.

It will be appreciated that although the embodiments of the power module 100 shown in FIGS. 1-6 depict two conductive overlays 102 coupled to two groups or sets of the one or more power transistors 108, embodiments with more and fewer conductive overlays 102 are contemplated.

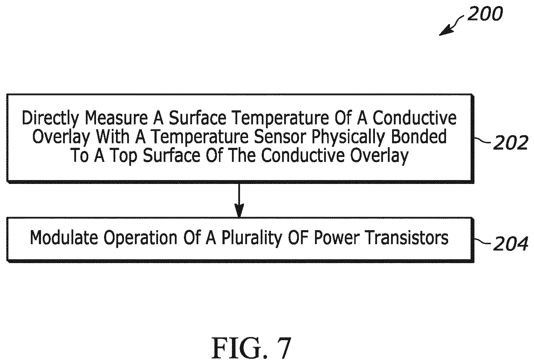

Turning now to FIG. 7, the embodiments described herein are also directed to a method 200 of controlling the power module 100 using the control circuit 118. According to a step 202 of the method 200, the temperature sensors 104 directly measure a surface temperature of the conductive overlays 102 and/or the current sensors 116 measure current flow. According to a step 204 of the method 200, the control circuit 118 modulates operation of the one or more power transistors 108, which are electrically coupled to the control circuit 118.

Modulating the operation of the power transistors 108 can be based on one or more of the direct measurement of the surface temperature with the temperature sensors 104 and the measurement of current flow from the plurality of current sensors 116. Further, modulating the operation of the power transistors 108 can include stopping operation of one, more, or all of the one or more power transistors 108 when the direct temperature measurement and or the current measurements exceed preconfigured threshold values. Further, modulating the operation of the power transistors 108 can include limiting operation of one, more, or all of the one or more power transistors 108 when the direct temperature measurement and or the current measurements exceed additionally preconfigured threshold values. Limiting the operation can include shutting down only some of the one or more power transistors 108 and/or changing operating parameters such as switching frequency, power input or the like such that the temperature and or current measurement values will be reduced to levels consistent with normal safe operation of the power module 100.

In some embodiments, the current sensors 116 can measure the current from different locations on the conductive overlays 102 in parallel. In these embodiments, incremental differences in the current from each location can be monitored and when the current value at one location deviates more than a preconfigured amount from the other current values, the control circuit 118 can modulate the operation of the power transistors 108 to avoid catastrophic failure. For example, such modulation can include shutting down operation of some or all power transistors 108. Further, in some embodiments, the control circuit can shutdown only ones of the power transistors 108 that are linked to the current sensors whose current value exceeded the preconfigured threshold.

## Claims

1. A power module (100) comprising:
one or more power transistors (108) each having a respective die surface;
a conductive overlay (102) electrically coupled to each of the one or more power transistors (108) over the respective die surface thereof; and **characterised in that** the power module further comprises
a temperature sensor physically bonded to a top surface of the conductive overlay (102) to provide a direct temperature measurement for the one or more power transistors (108).

2. The power module (100) of claim 1 further comprising:
a current sensor physically and electrically coupled to the conductive overlay (102) to measure current flow between two of the one or more power transistors (108).

3. The power module (100) of claim 2 wherein the current sensor comprises a current sensing shunt.

4. The power module (100) of claim 2 or 3 further comprising:
a control circuit (118) electrically coupled to the one or more power transistors (108), the temperature sensor, and the current sensor,
wherein the control circuit (118) is configured to modulate operation of the one or more power transistors (108) based on the direct temperature measurement from the temperature sensor and the measurement of current flow.

5. The power module (100) of claim 4 wherein modulating the operation of the one or more power transistors (108) includes stopping operation of the one or more power transistors (108) when the direct temperature measurement exceeds a threshold value.

6. The power module (100) of claim 4 wherein modulating the operation of the one or more power transistors (108) includes limiting operation of the one or more power transistors (108) when the direct temperature measurement exceeds a threshold value.

7. The power module (100) of any preceding claim wherein conductive overlay (102) is displaced a distance from the respective die surface of each of the one or more power transistors, and
wherein the conductive overlay (102) includes conductive vias (110) that bridge the distance to electrically couple the conductive overlay (102) to each of the one or more power transistors (108).

8. The power module (100) of any preceding claim, further comprising:
a control circuit (118) electrically coupled to the one or more power transistors (108) and the temperature sensor,
wherein the control circuit (118) is configured to modulate operation of the one or more power transistors (108) based on the direct temperature measurement from the temperature sensor.

9. The power module (100) of claim 8 wherein modulating the operation of the one or more power transistors (108) includes stopping operation of the one or more power transistors (108) when the direct temperature measurement exceeds a threshold value.

10. The power module (100) of claim 8 wherein modulating the operation of the one or more power transistors (108) includes limiting operation of the one or more power transistors (108) when the direct temperature measurement exceeds a threshold value.

11. A method comprising:
directly measuring a surface temperature of a conductive overlay (102) with a temperature sensor physically bonded to a top surface of the conductive overlay (102), the conductive overlay (102) being electrically coupled to one or more power transistors (108) over a respective die surface thereof; and
modulating operation of the one or more power transistors (108) with a control circuit (118) electrically coupled to the one or more power transistors (108), wherein the modulating is based on the direct measurement of the surface temperature.

12. A method of manufacturing a power module (100) comprising:
forming a conductive overlay on a first surface of one or more power transistors (108); **characterised in that** the method further comprises physically bonding a temperature sensor to a top surface of the conductive overlay.

13. The method of claim 12 further comprising physically and electrically coupling a current sensor to the conductive overlay at a location between two different ones of the one or more power transistors (108).

14. The method of claims 12 or 13 further comprising:
coupling a non-conductive layer (114) to the first surface of the one or more power transistors (108) via an adhesive layer (112); and
forming the conductive overlay over the non-conductive layer (114) with vias (110) that extend through the non-conductive layer (114) and the adhesive layer (112) to the first surface of the one or more power transistors (108).

15. The method of any of claims 12-14 further comprising electrically coupling the temperature sensor to a control circuit (118).

## Patentansprüche

1. Leistungsmodul (100), umfassend:
einen oder mehrere Leistungstransistoren (108), die jeweils eine entsprechende Die-Oberfläche aufweisen;
eine leitfähige Auflage (102), die mit jedem des einen oder der mehreren Leistungstransistoren (108) über der jeweiligen Die-Oberfläche davon elektrisch gekoppelt ist; und **dadurch gekennzeichnet, dass** das Leistungsmodul ferner umfasst
einen Temperatursensor, der an eine obere Oberfläche der leitfähigen Auflage (102) physikalisch gebunden ist, um eine direkte Temperaturmessung für den einen oder die mehreren Leistungstransistoren (108) bereitzustellen.

2. Leistungsmodul (100) nach Anspruch 1, ferner umfassend:
einen Stromsensor, der mit der leitfähigen Auflage (102) physikalisch und elektrisch gekoppelt ist, um einen Stromfluss zwischen zwei des einen oder der mehreren Leistungstransistoren (108) zu messen.

3. Leistungsmodul (100) nach Anspruch 2, wobei der Stromsensor einen Stromerfassungs-Shunt umfasst.

4. Leistungsmodul (100) nach Anspruch 2 oder 3, ferner umfassend:
eine Steuerschaltung (118), die mit dem einen oder den mehreren Leistungstransistoren (108), dem Temperatursensor und dem Stromsensor elektrisch gekoppelt ist,
wobei die Steuerschaltung (118) konfiguriert ist, um einen Betrieb des einen oder der mehreren Leistungstransistoren (108) basierend auf der direkten Temperaturmessung von dem Temperatursensor und der Messung des Stromflusses zu modulieren.

5. Leistungsmodul (100) nach Anspruch 4, wobei das Modulieren des Betriebs des einen oder der mehreren Leistungstransistoren (108) ein Stoppen des Betriebs des einen oder der mehreren Leistungstransistoren (108) umfasst, wenn die direkte Temperaturmessung einen Schwellenwert überschreitet.

6. Leistungsmodul (100) nach Anspruch 4, wobei das Modulieren des Betriebs des einen oder der mehreren Leistungstransistoren (108) ein Begrenzen des Betriebs des einen oder der mehreren Leistungstransistoren (108) umfasst, wenn die direkte Temperaturmessung einen Schwellenwert überschreitet.

7. Leistungsmodul (100) nach einem der vorstehenden Ansprüche, wobei die leitfähige Auflage (102) um einen Abstand von der jeweiligen Die-Oberfläche jedes des einen oder der mehreren Leistungstransistoren versetzt ist, und
wobei die leitfähige Auflage (102) leitfähige Durchkontaktierungen (110) einschließt, die den Abstand überbrücken, um die leitfähige Auflage (102) mit jedem des einen oder der mehreren Leistungstransistoren (108) elektrisch zu koppeln.

8. Leistungsmodul (100) nach einem der vorstehenden Ansprüche, ferner umfassend:
eine Steuerschaltung (118), die mit dem einen oder den mehreren Leistungstransistoren (108) und dem Temperatursensor elektrisch gekoppelt ist,
wobei die Steuerschaltung (118) konfiguriert ist, um den Betrieb des einen oder der mehreren Leistungstransistoren (108) basierend auf der direkten Temperaturmessung von dem Temperatursensor zu modulieren.

9. Leistungsmodul (100) nach Anspruch 8, wobei das Modulieren des Betriebs des einen oder der mehreren Leistungstransistoren (108) das Stoppen des Betriebs des einen oder der mehreren Leistungstransistoren (108) umfasst, wenn die direkte Temperaturmessung einen Schwellenwert überschreitet.

10. Leistungsmodul (100) nach Anspruch 8, wobei das Modulieren des Betriebs des einen oder der mehreren Leistungstransistoren (108) das Begrenzen des Betriebs des einen oder der mehreren Leistungstransistoren (108) umfasst, wenn die direkte Temperaturmessung einen Schwellenwert überschreitet.

11. Verfahren, umfassend:
direktes Messen einer Oberflächentemperatur einer leitfähigen Auflage (102) mit einem Temperatursensor, der an eine obere Oberfläche der leitfähigen Auflage (102) physikalisch gebunden ist, wobei die leitfähige Auflage (102) über eine entsprechende Die-Oberfläche davon mit einem oder mehreren Leistungstransistoren (108) elektrisch gekoppelt ist; und
Modulieren des Betriebs des einen oder der mehreren Leistungstransistoren (108) mit einer Steuerschaltung (118), die mit dem einen oder den mehreren Leistungstransistoren (108) elektrisch gekoppelt ist, wobei die Modulation auf der direkten Messung der Oberflächentemperatur basiert.

12. Verfahren zum Herstellen eines Leistungsmoduls (100), umfassend:
Ausbilden einer leitfähigen Auflageschicht auf einer ersten Oberfläche eines oder mehrerer Leistungstransistoren (108); **dadurch gekennzeichnet, dass** das Verfahren ferner umfasst:
physikalisches Binden eines Temperatursensors an eine obere Oberfläche der leitfähigen Auflage.

13. Verfahren nach Anspruch 12, das ferner das physikalische und elektrische Koppeln eines Stromsensors mit der leitfähigen Auflage an einer Stelle zwischen zwei verschiedenen des einen oder der mehreren Leistungstransistoren (108) umfasst.

14. Verfahren nach Anspruch 12 oder 13, ferner umfassend:
Koppeln einer nicht leitfähigen Schicht (114) mit der ersten Oberfläche des einen oder der mehreren Leistungstransistoren (108) über eine Klebeschicht (112); und
Ausbilden der leitfähigen Auflageschicht über der nicht leitfähigen Schicht (114) mit Durchkontaktierungen (110), die sich durch die nicht leitfähige Schicht (114) und die Klebeschicht (112) zu der ersten Oberfläche des einen oder der mehreren Leistungstransistoren (108) erstrecken.

15. Verfahren nach einem der Ansprüche 12 bis 14, ferner umfassend das elektrische Koppeln des Temperatursensors mit einer Steuerschaltung (118).

## Revendications

1. Module de puissance (100) comprenant :
un ou plusieurs transistors de puissance (108) ayant chacun une surface de puce nue respective ;
un recouvrement conducteur (102) couplé électriquement à chacun parmi le ou les transistors de puissance (108) par-dessus la surface de puce nue respective de ceux-ci ; et **caractérisé en ce que** le module de puissance comprend en outre
un capteur de température lié physiquement à une surface supérieure du recouvrement conducteur (102) pour fournir une mesure directe de température pour le ou les transistors de puissance (108).

2. Module de puissance (100) selon la revendication 1 comprenant en outre :
un capteur de courant accouplé physiquement et couplé électriquement au recouvrement conducteur (102) pour mesurer un flux de courant entre deux parmi le ou les transistors de puissance (108).

3. Module de puissance (100) selon la revendication 2 dans lequel le capteur de courant comprend une dérivation de captage de courant.

4. Module de puissance (100) selon la revendication 2 ou 3 comprenant en outre :
un circuit de commande (118) couplé électriquement au ou aux transistors de puissance (108), au capteur de température et au capteur de courant,
dans lequel le circuit de commande (118) est configuré pour moduler le fonctionnement du ou des transistors de puissance (108) en fonction de la mesure directe de température provenant du capteur de température et de la mesure de flux de courant.

5. Module de puissance (100) selon la revendication 4 dans lequel la modulation du fonctionnement du ou des transistors de puissance (108) comporte l'arrêt de fonctionnement du ou des transistors de puissance (108) lorsque la mesure directe de température dépasse une valeur seuil.

6. Module de puissance (100) selon la revendication 4 dans lequel la modulation du fonctionnement du ou des transistors de puissance (108) comporte la limitation de fonctionnement du ou des transistors de puissance (108) lorsque la mesure directe de température dépasse une valeur seuil.

7. Module de puissance (100) selon l'une quelconque revendication précédente dans lequel le recouvrement conducteur (102) est déplacé d'une distance par rapport à la surface de puce nue respective de chacun parmi le ou les transistors de puissance, et
dans lequel le recouvrement conducteur (102) comporte des interconnexions conductrices (110) qui couvrent la distance pour coupler électriquement le recouvrement conducteur (102) à chacun parmi le ou les transistors de puissance (108).

8. Module de puissance (100) selon l'une quelconque revendication précédente, comprenant en outre :
un circuit de commande (118) couplé électriquement au ou aux transistors de puissance (108) et au capteur de température,
dans lequel le circuit de commande (118) est configuré pour moduler le fonctionnement du ou des transistors de puissance (108) en fonction de la mesure directe de température provenant du capteur de température.

9. Module de puissance (100) selon la revendication 8 dans lequel la modulation du fonctionnement du ou des transistors de puissance (108) comporte l'arrêt de fonctionnement du ou des transistors de puissance (108) lorsque la mesure directe de température dépasse une valeur seuil.

10. Module de puissance (100) selon la revendication 8 dans lequel la modulation du fonctionnement du ou des transistors de puissance (108) comporte la limitation de fonctionnement du ou des transistors de puissance (108) lorsque la mesure directe de température dépasse une valeur seuil.

11. Procédé comprenant :
la mesure directe d'une température de surface d'un recouvrement conducteur (102) avec un capteur de température lié physiquement à une surface supérieure du recouvrement conducteur (102), le recouvrement conducteur (102) étant couplé électriquement à un ou plusieurs transistors de puissance (108) par-dessus une surface de puce nue respective de ceux-ci ; et
la modulation de fonctionnement du ou des transistors de puissance (108) avec un circuit de commande (118) couplé électriquement au ou aux transistors de puissance (108), dans lequel la modulation est en fonction de la mesure directe de la température de surface.

12. Procédé de fabrication d'un module de puissance (100) comprenant :
la formation d'un recouvrement conducteur sur une première surface d'un ou plusieurs transistors de puissance (108) ; **caractérisé en ce que** le procédé comprend en outre
la liaison physique d'un capteur de température à une surface supérieure du recouvrement conducteur.

13. Procédé selon la revendication 12 comprenant en outre l'accouplement physique et le couplage électrique d'un capteur de courant au recouvrement conducteur au niveau d'une localisation entre deux différents parmi le ou les transistors de puissance (108).

14. Procédé selon les revendications 12 ou 13 comprenant en outre :
l'accouplement d'une couche non conductrice (114) à la première surface du ou des transistors de puissance (108) par l'intermédiaire d'une couche adhésive (112) ; et
la formation du recouvrement conducteur par-dessus la couche non conductrice (114) avec des interconnexions (110) qui s'étendent à travers la couche non conductrice (114) et la couche adhésive (112) jusqu'à la première surface du ou des transistors de puissance (108).

15. Procédé selon l'une quelconque des revendications 12 à 14 comprenant en outre le couplage électrique du capteur de température à un circuit de commande (118).
